Europäisches Patentamt

European Patent Office

Office européen des brevets

(19)

(11) Publication number: **0 082 654**
**A1**

(12)

# EUROPEAN PATENT APPLICATION

(21) Application number: **82306626.1**

(22) Date of filing: **13.12.82**

(51) Int. Cl.³: **C 23 C 13/08**
**C 23 C 13/10, C 23 C 13/02**

(30) Priority: **19.12.81 GB 8138650**

(43) Date of publication of application:
**29.06.83 Bulletin 83/26**

(84) Designated Contracting States:
**DE FR GB IT**

(71) Applicant: **GENERAL ENGINEERING RADCLIFFE 1979 LIMITED**
**Bury Road**
**Radcliffe Manchester, M26 9UR(GB)**

(72) Inventor: **Sugden, George Barry**
**96 Rudgwick Drive**
**Bury Lancashire(GB)**

(74) Representative: **Downey, William Gerrard et al,**
**WILSON GUNN & ELLIS 41 Royal Exchange Cross Street**
**Manchester M2 7BD(GB)**

(54) Apparatus for and a method of coating a length of material.

(57) An apparatus for coating a web (W) comprises a vacuum chamber (1) housing a metal vapour source (2) adjacent a driven water cooled process drum (5). The web (W) is drawn over the drum (5) during operating and deposition of metal on the web (W) is monitored and controlled. The monitor (6) may comprise transmitters (T1 to T10) and receivers (C1 to C10) disposed on opposite sides respectively of the web (W) or transmitters (T1 to T10) and receivers (C1 to C10) on the same side of the web (W). The first arrangement works on a signal transmitted through the web (W) and the second on a signal reflected from the web (W). Received transmitted or reflected signals are used to vary process variables to achieve desired coating thicknesses.

FIG.1

EP 0 082 654 A1

./...

Fig. 2

-1-

## APPARATUS FOR AND A METHOD OF

## COATING A LENGTH OF MATERIAL.

The present invention relates to apparatus for and a method of coating a length of material by vacuum deposition.

In one such apparatus, the length of material is fed from a supply or pay off reel past a source of evaporated metal to a take-up reel in a vacuum chamber.  As the material, which is usually synthetic plastics material, passes by the source, evaporated metal, usually aluminium, condenses on the material to form a metal coating.  The characteristics of the coating are controlled manually by the operator of the apparatus by appropriate alteration of the metallising process variables. This requires the close and substantially continuous attendance of a skilled operative.

According to one aspect of the present invention, there is provided apparatus for coating a length of material comprising a vacuum chamber housing supply means for the supply of the length of material to be coated, a source of coating material, take-up means for receiving the length of coated material, and a monitor for monitoring the coating process;

and control means operative to receive signals from the monitor and to vary the process variables in dependence upon the signals received in order to secure desired coating characteristics.

A preferred embodiment of the apparatus may comprise any one or more of the following advantageous features:-

(a) The monitor comprises a transmitter disposed on one side of the length of material and a receiver disposed on the other side of the material to receive a signal from the transmitter transmitted through the material.

(b) The monitor comprises a transmitter disposed adjacent the path followed, in operation of the machine, by the length of material and a receiver also disposed adjacent that path but spaced from the transmitter to receive signals from the transmitter reflected by the material.

(c)   The monitor comprises a series of transmitters disposed on one side of the length of material and a series of receivers disposed on the other side of the material to receive signals from the transmitters transmitted through the material.

(d)   The monitor comprises a series of transmitters disposed adjacent the path followed, in operation of the machine, by the length of material and a series of receivers also disposed adjacent that path but spaced from the transmitters to receive signals from the transmitters reflected by the material.

(e)   The monitor comprises a transmitter and a receiver spaced from the transmitter, and is disposed to monitor the density of a cloud of coating material emanating, in operation of the machine, from the source of coating material and thereby to monitor the thickness of metal coating produced thereby.

0082654

-4-

(f)  The monitor comprises a series of transmitters and a series of receivers spaced from the transmitters and is disposed to monitor the density of a cloud of coating material emanating, in operation of the machine, from the source of coating material and thereby to monitor the thickness of metal coating produced thereby.

(g)  The or each receiver of the monitor of (b) or (d) is provided with circuitry set to respond to electrical signals produced by received transmitted or reflected signals of a particular frequency, the frequency being chosen having regard to a desired colouration effect.

(h)  The or each receiver is provided with circuitry set to respond to electrical signals produced by received transmitted or reflected signals of a particular frequency.

(i)  The or each transmitter is a phototransistor.

(j)   The or each receiver is a photocell.

(k)   The control means comprises a micro-
      processor.

(l)   The control means is operative to
      control the speed of operation of
      means for receiving the length of
      coated material.

(m)   The control means is operative to
      control the rate of supply of coating
      material.

According to another aspect of the present
invention, there is provided a method of coating
a length of material including the steps drawing
the material past a source of coating material in
a vacuum, monitoring the thickness of a coating
produced thereby and automatically controlling
the process variables in order to maintain the coating thickness at a chosen nominal value.

The invention also comprises coated material
produced with the above described apparatus or
method.

In the specification the term vacuum is used to encompass pressures less than the normal ambient pressure appropriate to the coating process.

In order that the invention may be more clearly understood, one embodiment thereof will now be described, by way of example, with reference to the accompanying drawings, in which:-

Figure 1 shows a front elevational view in section of a web metallising apparatus,

Figure 2 shows diagrammatically a monitor forming part of the apparatus of Figure 1 with associated control circuitry, and

Figure 3 shows diagrammatically an end elevational view of a modification of the monitor shown in Figure 1.

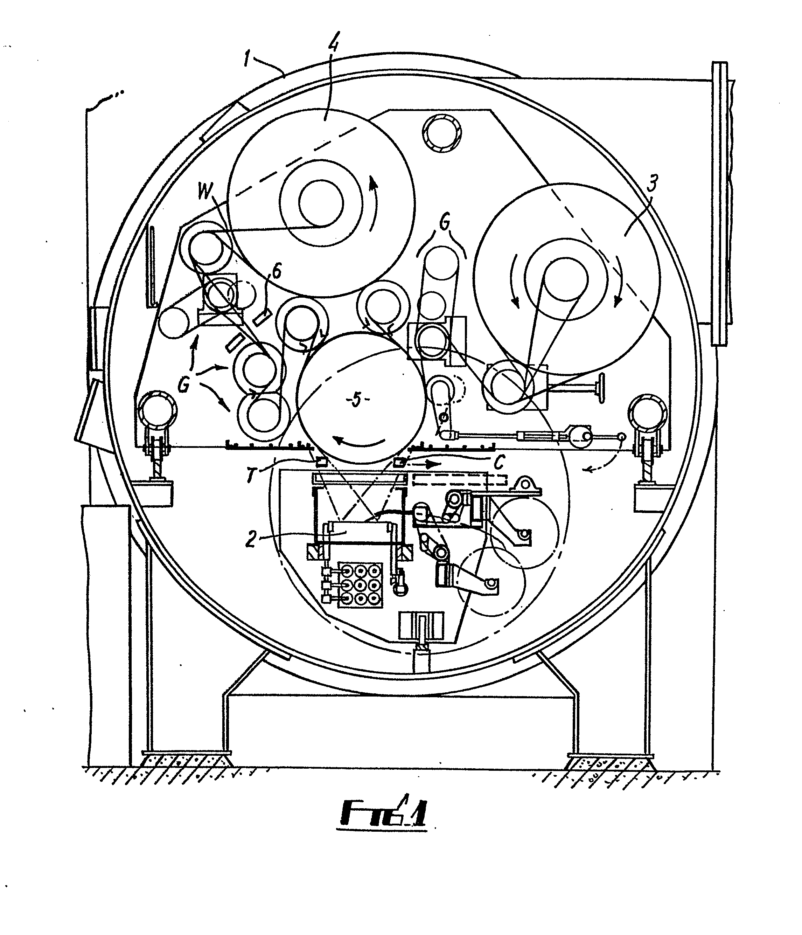

Referring to Figure 1, the web metallising apparatus comprises a vacuum chamber 1 housing a metal (usually aluminium) vapour source 2, a pay off or supply reel 3 a driven take-up reel 4 and a driven water cooled drum 5. The web (referenced W in Figure 1) follows a complex path defined by a series of guide rolls in conjunction with the surface of drum 5 from the supply reel 3 to the take-up reel 4. The guide rolls are indicated generally by the reference G in Figure 1. In operation, untreated web is fed from the supply reel 3 and is cooled as it passes over the working surface of the water cooled drum 5. As it passes over this working surface a cloud of metal vapour condenses on the surface of the web facing the source 2. The metallised web then passes to the take-up reel 4.

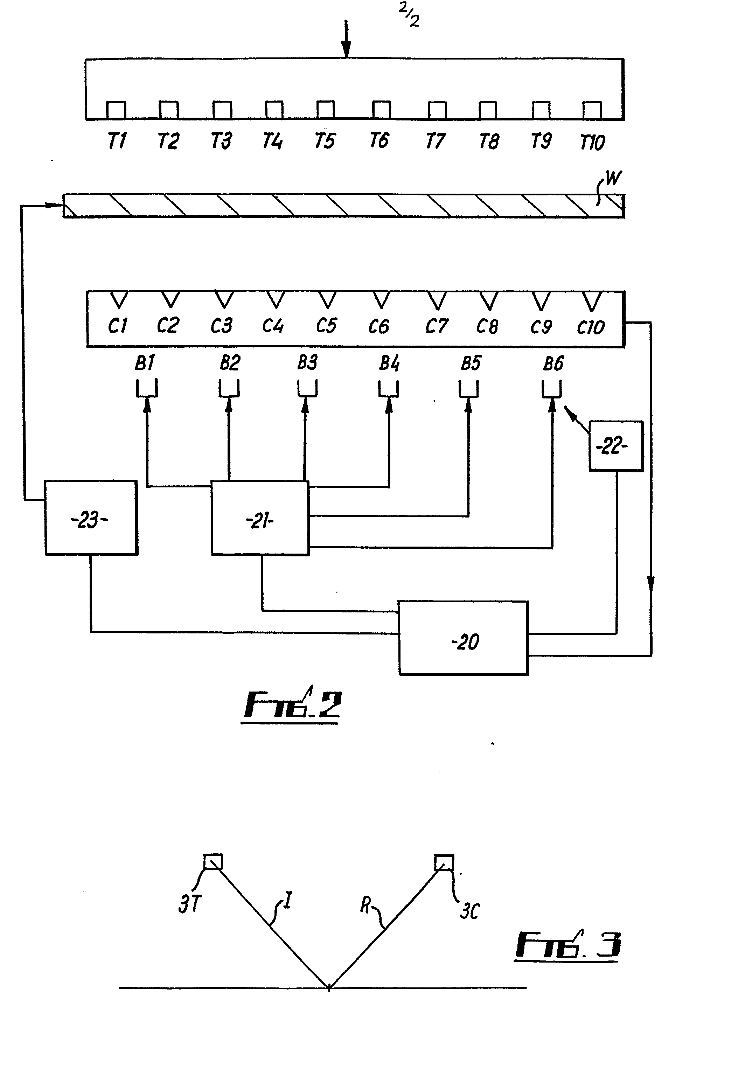

The characteristics of the coating are monitored by means of a monitor 6 disposed between the driven water cooled drum 5 and the take-up reel 4. Referring to Figure 2, this monitor 6 comprises ten phototransistors T1 to T10 arranged in line but regularly spaced from one another on one side of the metallised web W and ten photo-cells C1 to C10 also arranged correspondingly in line but regularly spaced fron one another on the other side of the metallised web W. The photo-transistors T1 to T10 are activated to emit light signals of a particular frequency and the photocells are provided with circuitry set to respond to electrical signals corresponding to light signals of that frequency. Variations in ambient light conditions therefore do not effect the system.

The amount of light emanating from the photo-transistors T1 to T10 which is transmitted by the web to the photocells C1 to C10 depends upon the thickness of the coating of metal on the web. The signal generated by each of the photocells is therefore a measure of the coating thickness of the metal coating on the web adjacent that photocell. The signals from the photocells are fed to a control 20. The function of the control 20 is to analyse the signals received and issue instructions to vary the metallising process variables in order to secure the desired coating thickness across the width of the web W. The main metallising process variables are the web speed and the amount of metal vapourised per unit·time. This latter variable is in turn dependant upon the aluminium wire feed speed to the vapour source and upon the temperature of the source. Pressure within the vacuum chamber 1 also effects metallising.

The metal vapour source 2 comprises six
individual molten metal baths Bl to B6.  These
baths are of course displaced from the monitor
6 as shown in Figure 1, but they have been superimposed on Figure 2 in order to show their
postion in relation to the web as compared with the
position in relation to the web of the photocells and phototransistors of the monitor. There
is a metal wire feed 21 to each of these baths
Bl to B6 and the speed of each feed is controlled
by signals issuing from control 20.  Similarly,
the power supply 22 to the baths Bl to B6 can be
varied in order to vary the temperature of each
bath and the amount of power supplied is also controlled by signals issued by control 20.  Web
speed is controlled by controlling the speed of
the water cooled drum 5.  The drive for this water
cooled drum 5 is represented diagrammatically
on Figure 2 at 23.  This drive 23 is arranged to
receive control signals from the control 20.

The control 20 comprises a microprocessor
although controls of less complexity would be used.
In operation of the apparatus the desired nominal
thickness of the metal coating and the acceptable
tolerances are chosen.  The microprocessor is programmed to alter the metallising process variables described above in order to maintain the coating thickness substantially at the chosen value and within the accepted tolerances band. If, for example, coating thickness begins to exceed or fall below the chosen value at a point within the width of the web the aluminium wire feed can be reduced or increased respectively to the molten metal bath most closely adjacent that bath. If, on the other hand, the coating thickness across the whole width of the web exceeds or falls below the chosen value it may be more appropriate to increase or reduce respectively the speed of the web. In practice the microprocessor will continuously receive signals from all of the photocells and compute the values of the process variable in accordance with its program necessary to ensure that coating thickness remains at the selected nominal value and within the allowable tolerance band. These process variable values are in turn continuously fed to those parts of the apparatus provided for altering the process variables in question.

A modification of the monitoring system is diagrammatically illustrated in Figure 3. In this modified system a line of receivers 3C and a line of corresponding transmitters 3T spaced from the line of receivers are both disposed in the same side of the length of material being monitored and the receivers receive the signals reflected by the web as diagrammatically indicated in Figure 3 by lines I and R. The degree of reflection of the incident signal I will be governed by the coating on the web and in particular by the thickness of that coating. This modified system is intended to cater for those cases where a more accurate thickness reading can be obtained by a reflected signal than by a transmitted signal. In all other respects the system of Figure 3 is the same as that of Figure 2. Both the systems of Figures 2 and 3 can be set up to cater for received signals of a particular frequency and in that way colouration effects of the coating on the web and in particular, any deviation therefrom can be monitored. This would normally be achieved by connecting appropriate circuitry to the receivers C1 to C10 or 3C provided, preferably, with means for adjusting the frequency responded to.

The thickness of the coating on the web can also be monitored, in conjunction with web speed, by monitoring the density of the cloud of metallising vapour between the source of the vapour and the surface of the web W. A possible position for a line of transmitters and a line of receivers of this type of monitor is illustrated at T and C in Figure 1. As with the previously described embodiments, the transmitters and receivers of the respective lines are spaced across the width of the web W. In other respects this type of monitor is similar to the previously described monitor, in particular having circuitry associated with the transmitters and receivers for processing the signals received and producing control signals therefrom.

It will be appreciated that the above embodiments have been described by way of example only and that many variations are possible without departing from the scope of the invention.

-13-

## CLAIMS

1. Apparatus for coating a length of material comprising a vacuum chamber (1) housing supply means (3) for the supply of the length of material (W) to be coated, a source (2) of coating material, and take-up means (4) for receiving the length of coated material, characterised by a monitor (6, 3C, 3T) for monitoring the coating process; and control means (20) operative to receive signals from the monitor and to vary the process variables in dependence upon the signals received in order to secure desired coating characteristics.

2. Apparatus as claimed in claim 1, in which the monitor (6) comprises a transmitter (T1 to T10) disposed on one side of the length of material and a receiver (C1 to C10) disposed on the other side of the material to receive a signal from the transmitter transmitted through the material (W).

3. Apparatus as claimed in claim 1, in which the monitor (3C, 3T) comprises a transmitter (3T) disposed adjacent the path followed, in operation of the machine, by the length of material (W) and a receiver (3C) also disposed adjacent that path but spaced from the transmitter (3T) to receive signals from the transmitter reflected by the material (W).

4. Apparatus as claimed in Claim 1, in which the monitor comprises a series of transmitters (T1 to T10) disposed on one side of the length of material and a series of receivers (C1 to C10) disposed on the other side of the material to receive signals from the transmitters transmitted through the material (W).

5. Apparatus as claimed in Claim 1, in which the monitor (3C, 3T) comprises a series of transmitters (3T) disposed adjacent the path followed, in operation of the machine, by the length of material (W) and a series of receivers (3C) also disposed adjacent that path but spaced from the transmitters (3T) to receive signals from the transmitters reflected by the material (W).

6. Apparatus as claimed in Claim 1, in which the monitor comprises a transmitter and a receiver spaced from the transmitter, and is disposed to monitor the density of a cloud of coating material emanating, in operation of the machine, from the source (2) of coating material and thereby to monitor the thickness of metal coating produced thereby.

7. Apparatus as claimed in Claim 1, in which the monitor comprises a series of transmitters and a series of receivers spaced from the transmitters and is disposed to monitor the density of a cloud of coating material emanating, in operation of the machine, from the source (2) of coating material and thereby to monitor the thickness of metal coating produced thereby.

8. Apparatus as claimed in any preceding claim, in which a receiver (C1 to C10, 3C) of the monitor is provided with circuitry (20) set to respond to electrical signals produced by received signals of a particular frequency.

9. Apparatus as claimed in Claim 8, in which the particular frequency is chosen having regard to the desired colouration effect.

10. Apparatus as claimed in anypreceding claim, in which the control means (20) is operative to control the speed of operation of means for receiving (4) the length of coated material.

11. Apparatus as claimed in any preceding claim, in which the control means (20) is operative to control the rate of supply of coating material.

12. A method of coating a length of material including the steps drawing the material (W) past a source (2) of coating material in a vacuum, monitoring the thickness of a coating produced thereby and automatically controlling the process variables in order to maintain the coating thickness at a chosen nominal value.

13. A method as claimed in Claim 12, in which the thickness of the coating is monitored by transmitting a signal through the material and assessing the characteristics of the received signal.

14. A method as claimed in claim 12, in which the thickness of the coating is monitored by transmitting a signal towards the material and assessing the characteristics of the signal reflected from the material.

15. A method as claimed in Claim 12, 13 or 14, in which the speed of operation of the means for receiving (4) the length of coated material (W) is controlled by the control means (20).

16. A method as claimed in Claim 12, 13, 14 or
15 in which the rate of supply of the coating material
is controlled by the control means (20)

Fig.1

0082654

$^2/_2$

_Fig.2_

_Fig.3_

**European Patent Office**

## EUROPEAN SEARCH REPORT

| | DOCUMENTS CONSIDERED TO BE RELEVANT | | EP 82306626.1 |
|---|---|---|---|

| Category | Citation of document with indication, where appropriate, of relevant passages | Relevant to claim | CLASSIFICATION OF THE APPLICATION (Int Cl ³) |
|---|---|---|---|
| X | PATENTS ABSTRACTS OF JAPAN, unexamined applications, C section, vol. 1, no. 106, September 19, 1977<br><br>THE PATENT OFFICE JAPANESE GOVERNMENT<br>page 2514 C 77<br><br>   * Kokai-no. 52-71 389 (NIPPON SHINKU GIJUTSU K.K.) *<br><br>-- | 1,12 | C 23 C 13/08<br>C 23 C 13/10<br>C 23 C 13/02 |
| Y | PATENT ABSTRACTS OF JAPAN, unexamined applications, C field, vol. 6, no. 49, March 31, 1982<br><br>THE PATENT OFFICE JAPANESE GOVERNMENT<br>page 58 C 96<br><br>   * Kokai-no. 56-163 262 (NIPPON SHINKU GIJUTSU K.K.) *<br><br>---- | 1,12 | |
| | | | **TECHNICAL FIELDS SEARCHED (Int. Cl. ³)**<br><br>C 23 C |

The present search report has been drawn up for all claims

| Place of search | Date of completion of the search | Examiner |
|---|---|---|
| VIENNA | 22-02-1983 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82